# EUROPÄISCHE PATENTSCHRIFT

(11) **EP 0 516 742 B1**
(45) Veröffentlichungstag und Bekanntmachung des Hinweises auf die Patenterteilung: **31.08.1994**
(21) Anmeldenummer: 91905622.6
(22) Anmeldetag: 22.02.1991
(51) Int. Cl.: B01J 13/16, B41M 5/28

(54) **EINE WÄSSRIGE PHASE ENTHALTENDE MIKROKAPSELN**
MICROCAPSULES CONTAINING AN AQUEOUS PHASE
MICROCAPSULES CONTENANT UNE PHASE AQUEUSE

(30) Priorität: 02.03.1990 DE 4006613
(43) Veröffentlichungstag der Anmeldung: 09.12.1992
(73) Patentinhaber: EASTMAN KODAK COMPANY, Rochester, New York 14650 (US)
(72) Erfinder: NUYKEN, Oskar, D-8000 München 81 (DE); DAUTH, Jochen, D-8580 Bayreuth (DE); PEKRUHN, Wolfgang, D-1000 Berlin 33 (DE)
(74) Vertreter: Pohle, Reinhard, Dipl.-Phys.
(86) Internationale Anmeldenummer: DE9100167
(87) Internationale Veröffentlichungsnummer: WO9112884

(56) Entgegenhaltungen:
- DE-A- 1 542 260
- DE-A- 3 918 146
- Patent abstracts of Japan, Band 11, Nr. 159, (C-423) (2606), 22 Mai 1987
- Patent Abstract of Japan, Band 12, Nr. 421 (c541)(3268)8. November 1988

## Beschreibung

Die Erfindung betrifft eine wäßrige Phase enthaltende Mikrokapseln sowie ein Verfahren zu ihrer Herstellung.

Mikrokapseln bestehen aus einem Kern und einer diesen Kern vollständig umschließenden Kapselwand. Sie weisen eine Größe von ca. 1 µm bis mehrere Millimeter auf. Verfahren zur Herstellung von Mikrokapseln mit polymerer Kapselwand und verschiedene Anwendungsmöglichkeiten für Mikrokapseln sind aus Angewandte Chemie, 1975, Seiten 556 bis 567 bekannt. Kern einer Mikrokapsel kann ein Feststoff, eine flüssige Phase oder auch ein Hohlraum sein, der von der Kapselwand vollständig umgeben ist. Je nach Verwendungszweck kann eine solche Mikrokapsel eine Wirksubstanz enthalten, die durch die Kapselwand gegenüber der Umgebung isoliert ist. Wird für die Kapselwand ein permeables Polymer gewählt, kann der Kapselinhalt bzw. der Wirkstoff langsam und kontinuierlich freigesetzt werden. Häufigere Anwendungen finden jedoch Mikrokapseln, die eine undurchlässige Kapselwand aufweisen und ihren Wirkstoff erst durch gezieltes Einwirken auf die Mikrokapsel freisetzen.

Das Öffnen einer Mikrokapsel kann dabei mechanisch von außen, beispielsweise durch Scheren oder Zerdrücken, thermisch durch Schmelzen oder Zersetzen der Kapselwand, durch Erhitzen des flüssigen Kapselinhalts über den Siedepunkt, durch Auflösen in Lösungsmittel oder durch chemische Einwirkung erfolgen.

Zur Mikroverkapselung von Wirkstoffen sind verschiedene mechanisch-physikalische und auch chemische Verfahren bekannt. Dazu gehört die Grenzflächen-Polykondensation, die an den Grenzflächen einer Dispersion aus zwei nicht miteinander mischbaren Flüssigkeiten stattfindet. Die Reaktionspartner dieser Polykondensation sind dabei in verschiedenen Phasen enthalten. Die Feinheit der Dispersion bzw. der Durchmesser der dispergierten Tröpfchen, die den späteren Mikrokapseln entsprechen, kann zum Beispiel durch Variation der Rührgeschwindigkeit eingestellt werden. Durch die Ausbildung der Kapselwand an der Grenzfläche der dispergierten Tröpfchen werden diese im Inneren der Kapsel eingeschlossen.

Bekannt ist eine Verwendung von Mikrokapseln zum Beispiel für Reaktionsschreibpapiere nach dem "self-contained-Typ". Diese Papiere werden mit einem Bindemittel und Mikrokapseln beschichtet, welche einen Farbbildner enthalten. Außerdem ist in der Beschichtung eine Entwicklersubstanz enthalten, die mit dem unter dem Druck eines Schreibgerätes freigesetzten Farbbildner sofort eine sichtbare Farbreaktion erzeugt und so gewissermaßen eine im Papier enthaltene Tinte darstellt.

Eine weitere Verwendung von Mikrokapseln ist aus der GB-A 2 173 452 in Verbindung mit einem Bildaufzeichnungsverfahren bekannt. Einen Farbstoff enthaltende Mikrokapseln werden dabei auf einem Aufzeichnungsträger aufgebracht, entsprechend einem gewünschten Bild durch einen Laserstrahl aufgebrochen und somit zumindest für die Tinte durchlässig gemacht. Dieses Bild wird schließlich auf Papier übertragen. Wie dies aber erreicht wird, und welche Kapselwandpolymere hierfür geeignet sind, ist aus dieser Schrift nicht zu entnehmen.

Nachteilig an bekannten Mikrokapseln ist, daß zum Aufbrechen der Kapselwandpolymere ein relativ hoher Energieaufwand erforderlich ist. Bei thermischer Zersetzung der Kapselwand lassen sich außerdem die Zersetzungsbedingungen des Kapselwandpolymeren nicht scharf definieren, so daß die Zersetzung beispielsweise in einem breiten Temperaturintervall stattfinden kann.

Aus "Abstract of Japan, Bd. 11 No. 159, C-423/2606, 1987" sind Mikrokapseln mit hydrophobem Kernmaterial und einem Wandmaterial bekannt, welchese Azo-Gruppen (-N = N-) aufweist. Hieraus ergibt sich auch die Herstellung der Mikrokapseln aus einer Öl-in-Wasser-Emulsion.

Aufgabe der vorliegenden Erfindung ist es daher, Mikrokapseln anzugeben, die sich thermisch und/oder durch Licht zersetzen lassen, die einen scharfen Zersetzungspunkt aufweisen, zur Zersetzung eine geringere Energieübertragung erfordern und die außerdem einfach herzustellen sind.

Diese Aufgabe wird erfindungsgemäß gelöst durch ein Verfahren zum Erzeugen von eine wäßrige Phase enthaltenden thermo- und/oder photolabilen Mikrokapseln durch Grenzflächenpolykondensation einer durch ein Dispersionsmittel stabilisierten Dispersion mit wäßrgem Kontinuum, wobei die Grenzflächenpolykondensation zwischen zwei, in unterschiedlichen Phasen vorliegenden mehrfunktionellen Reaktionspartnern stattfindet, von denen zumindest einer eine Azo- (- N = N -) oder Peroxogruppe (- O - O -) aufweist.

Weitere Ausgestaltungen der Erfindung sind den Unteransprüchen 2 bis 5, die so hergestellten Mikrokapseln selbst den Ansprüchen 6 bis 9 zu entnehmen.

Mit dem erfindungsgemäßen Verfahren gelingt es, thermo- und/oder photolabile Mikrokapseln in einem einfachen Verfahren aus geeigneten Monomeren aufzubauen. Über die Grenzflächenpolykondensation erschließt sich eine Reihe verschiedener Polymerklassen, die jeweils von der Art der funktionellen Gruppen der Reaktionspartner bzw. vom Typ der Kondensationsreaktionen abhängig ist. Die Kondensation selbst kann bereits bei Raumtemperatur durchgeführt werden, so daß keine Gefahr einer vorzeitigen Zersetzung der zum Beispiel thermolabilen Reaktionspartner besteht. Durch die Verfahrensbedingungen läßt sich auch ein Teil der nicht durch die Chemie bestimmten Eigenschaften der herzustellenden Mikrokapseln bestimmen. Entscheidend für die Verwendbarkeit einer Mikrokapsel ist unter anderem deren mechanische Stabilität, die wiederum unter anderem vom Durchmesser der Mikrokapseln bzw. vom Verhältnis des Durchmessers zur Wandstärke abhängig ist. Mit geringem werdendem Kapseldurchmesser erhöht sich die relative mechanische Stabilität der Mikrokapseln. Anwendungsbezogen kann auch ein geringerer Kapseldurchmesser dann Vorteile bringen, wenn bei der Zerstörung der Mikrokapseln nur wenig vom Mikrokapselinhalt freigesetzt werden soll, welcher üblicherweise einen Wirkstoff enthält. Insbesondere bei Thermodruckverfahren, wo durch gezieltes thermisches "Ansprechen" der Mikrokapseln ein Farbstoff freigesetzt bzw. erzeugt wird, ist eine relativ geringe Kapselgröße für eine hohe Druckqualität unläßlich.

Die Einstellung des Durchmessers der im erfindungsgemäßen Verfahren herzustellenden Mikrokapseln gelingt in einfacher Art und Weise durch die Einstellung der Feinheit der Dispersion. Diese wiederum läßt sich beispielsweise durch Variation der Rührgeschwindigkeit bei der Herstellung der Dispersion regeln.

Für das erfindungsgemäße Verfahren geeignete mehrfunktionelle Reaktionspartner mit labilen Gruppen entsprechen der Formel

R¹ - A - R²

bei der A der labilen Gruppe entspricht und für - O - O - oder - N = N - steht. Die Reste R¹ und R² sind so gewählt, daß sie trotz labiler Gruppe eine ausreichende Stabilität der Verbindung gewährleisten. Beide Reste, die gleich oder verschieden sind tragen zumindest eine reaktive funktionelle Gruppe und sind unabhängig voneinander ausgewählt aus 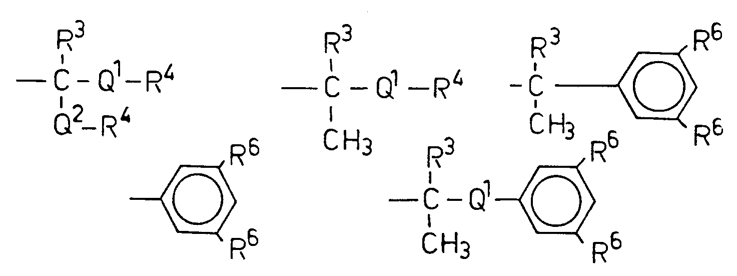
wobei R³ - CN, - Me oder - OAc ist, R⁴ für - COX, - NH₂, - NR⁵H, - SO₂Cl, - OH oder - NCO steht, R⁵ ein Alkylrest ist, R⁶ - NH₂, - NHR⁵ oder - OH bedeutet, Q¹ und Q² unabhängig voneinander einen zweiwertigen Alkyl- oder Arylrest darstellen und X Halogen oder H ist.

Die angegebenen Verbindungen lassen sich mit entsprechend reaktiven ebenfalls mehrfunktionellen Partnern zu Polykondensationsprodukten umsetzen, wobei Polymere aus der Klasse der Polyamide, Polycarbonate Polyester, Polyharnstoffe oder Polyurethane erhalten werden. Die beiden Reaktionspartner, die natürlich miteinander reagierende funktionelle Gruppen aufweisen, müssen sich zusätzlich im Lösungsverhalten unterscheiden. Während einer der Reaktionspartner wasserlöslich ist, muß der andere in einem organischen, nicht mit Wasser mischbaren Lösungsmittel gelöst werden. Ob der die labile Gruppe tragende Reaktionspartner dabei in der wäßrigen oder in der organischen Phase vorliegt, ist für die zu erzeugende Mikrokapsel ohne Bedeutung. Entscheidend ist vielmehr, daß ein Dispersionsmittel gewählt wird, welches die wäßrige Phase zum Kontinuum und die organische Phase zur Flotte macht. Unter Kontinuum versteht man bei der Dispersion diejenige Phase, die tröpfchenförmig vorliegt und bei der Grenzflächenpolykondensation schließlich den Kapselinhalt ergibt, da sich die Kapselwand an der Grenzfläche zwischen dem Kontinuum und der gewissermaßen das Lösungsmittel darstellenden anderen Phase (Flotte) herausbildet. Entscheidend für die Zuordnung der Phasen in der Dispersion ist nicht das Mengenverhältnis der Lösungsmittel, sondern ausschließlich das verwendete Dispersionsmittel. Ist das Kontinuum wie im angegebenen Fall eine wäßrige Phase, spricht man von einer inversen Mikroverkapselung.

Als besonders vorteilhafte Dispersionsmittel haben sich Suspendierhilfen der Span Ⓡ -Reihe herausgestellt. Dabei handelt es sich um teilweise mehrfach mit einer Fettsäure verestertes cyclisiertes Sorbit, wobei das Grundgerüst noch mit weiteren, von oberflächenaktiven Verbindungen bekannten Resten substituiert sein kann, beispielsweise mit Polyoxyethylen. Doch auch andere nicht ionische Emulgatoren sind geeignet.

Das auch als Schutzkolloid bezeichnete Dispersionsmittel vermag eine einmal erzeugte Dispersion zu stabilisieren und verhindert dabei gleichzeitig eine vorzeitige Hydrolyse von dafür empfindlichen Verbindungen, beispielsweise der Säurechloride und der Isocyanate.

Zur Durchführung des Verfahrens wird zunächst eine Dispersion aus einer wäßrigen Phase, die den Wirkstoff enthalten kann und einer weiteren organischen Phase hergestellt. Neben dem Wirkstoff ist in der wäßrigen Phase zusätzlich noch der wasserlösliche Reaktionspartner der Polykondensationsreaktion enthalten. Das Dispersionsmittel wird üblicherweise in der organischen Phase gelöst oder mit dieser vereinigt. Zum Beispiel durch kräftiges Rühren werden beide Phasen derart vermischt, bis ein gewünschter mittlerer Tröpfchendurchmesser der Dispersion erhalten wird. Für Mikrokapseln im µm-Bereich sind dazu Rührgeschwindigkeiten von mehr als 1000 U/min erforderlich. Die Rührgeschwindigkeit kann danach wieder reduziert werden, ohne daß die Stabilität der Dispersion gefährdet ist.

Zum Starten der Polykondensationsreaktion wird nun der zweite Reaktionspartner in einem organischen Lösungsmittel gelöst und langsam zur Dispersion zugegeben. Die Reaktion setzt spontan ein, so daß bei entsprechend langsamer Zugabe die Reaktionspartner sofort miteinander abreagieren. Zur Sicherheit wird am Schluß noch ca. 30 Minuten nachgerührt.

Auf diese Art und Weise können Verbindungen der allgemeinen Struktur

R¹ - N = N - R²

der Polykondensation unterworfen werden, wobei die Reste R¹ und R² gleich oder verschieden und im letzteren Fall zumindest gleiche funktionelle Gruppen aufweisen und den folgenden Strukturen gehorchen: 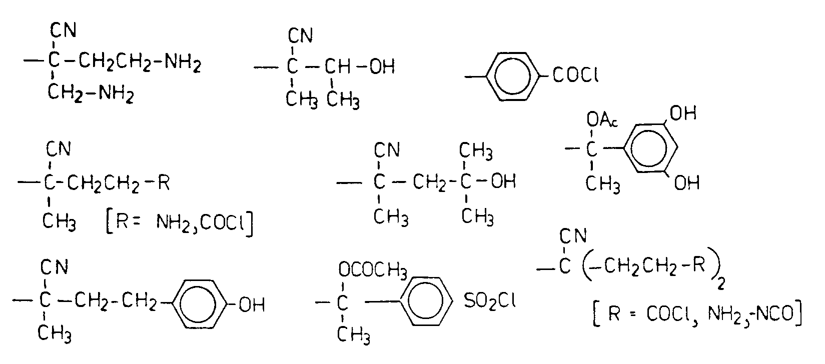
Die angegebenen Verbindungen mit Säurechlorid und Isocyanatendgruppen lassen sich beispielsweise mit niedermolekularen wasserlöslichen Alkoholen oder Aminen umsetzen und sind selbst in der organischen Phase löslich. Mangels wasserlöslichem Reaktionspartner müssen die Verbindungen mit alkoholischem bzw. phenolischem OH zunächst in das wasserlösliche Anion bzw. die wasserlösliche Additionsverbindung überführt werden. Alkohole werden daher durch Zugabe von Alkalihydroxyd in die entsprechenden wasserlöslichen Alkoholate bzw. Phenolate umgewandelt. Die Amine werden in die Additionsverbindungen mit zum Beispiel Halogenwasserstoffsäuren überführt. Beispielsweise als Hydrochloride sind die Amine gut wasserlöslich und können so in der Polykondensationsreaktion mit in der organischen Phase löslichen Reaktionspartnern umgesetzt werden. Somit ergibt sich zur Herstellung der erfindungsgemäßen Mikrokapseln eine größere Auswahl an möglichen Reaktionspartnern für die Polykondensationsreaktion. Dadurch werden dem Verfahren auch weitere Polymere mit verschiedenen Eigenschaften zugänglich.

Zur Umsetzung von Isocyanaten mit Aminen oder Alkoholen wird der organischen Phase üblicherweise eine katalytisch wirkende Menge eines Reaktionsbeschleunigers, beispielsweise eine Starterverbindung wie Diazabicyclooctan (DABCO) zugesetzt.

Nach grundsätzlich gleichem Verfahren gelingt die Einkapselung von Suspensionen bzw. die Herstellung von Mikrokapseln, welche mit der wäßrigen Suspension eines Feststoffes gefüllt sind. Dazu wird der entsprechende Feststoff vor der Herstellung der Dispersion zunächst in der wäßrigen Phase suspendiert. Mit geeigneten Dispersionsmitteln wie zum Beispiel den Verbindungen aus der Span Ⓡ -Reihe bleibt der Feststoff auch in der Dispersion im wäßrigen Kontinuum und wird daher vollständig eingekapselt.

Die so hergestellten Mikrokapseln weisen ein Kapselwandpolymer auf, das in gängigen Lösungsmitteln völlig unlöslich ist und enthaltene Wirkstoffe bzw. wäßrige Phasen langfristig und dicht gegenüber der Umgebung abkapselt. Die thermisch mechanischen Eigenschaften (zum Beispiel Glasübergangstemperatur, Härte usw.) der Mikrokapseln bzw. der Kapselwandpolymere lassen sich über die Vernetzungsdichte des Polymeren einstellen. Die Vernetzungsdichte ist eine Funktion der Anzahl der funktionellen Gruppen, die die einzelnen Moleküle der beiden Reaktionspartner der Polykondensation aufweisen. Bei Umsetzung von jeweils zwei funktionelle Gruppen aufweisenden Reaktionspartnern entsteht ein unvernetztes Polymer. Je mehr funktionelle Gruppen die Reaktionspartner aufweisen, umso höher wird die Vernetzungsdichte, was auch zur wirksameren Einkapselung angestrebt wird.

Mit den beispielhaft angegebenen Verbindungen werden Mikrokapseln hergestellt, deren Polymere eine Zersetzungstemperatur von 140 bis 250°C aufweisen. Die insbesondere durch aromatische Reste stabilisierten und daher eine höhere Zersetzungstemperatur aufweisenden Polymere besitzen gleichzeitig eine höhere Empfindlichkeit gegenüber eine photolytischen Zersetzung. Der thermische Zersetzungspunkt kann über eine Variation der chemischen Struktur exakt und in engen Grenzen eingestellt werden. Das thermische "Ansprechen" der Mikrokapseln kann durch freiwerdende Reaktionswärme und beim Zerfall freigesetztes Gas (N₂ oder O₂) unterstützt werden. Zum Freisetzen des Kapselinhalts wird daher weniger Energie benötigt, was bei Anwendungen zum Thermodrucken beispielsweise die maximal mögliche Druckgeschwindigkeit erhöht.

Ein weiterer Vorteil der thermo- und/oder photolabilen Mikrokapseln ist der wäßrige Inhalt, der vor allem bei Anwendungen in geschlossenen Räumen gegenüber organischen Lösungsmitteln bezüglich der physiologischen Wirkungen Vorteile besitzt. Vor allem werden auch Anwendungen im Lebensmittel- oder Agrarbereich denkbar, die bei Verwendung von zumeist giftigen Lösungsmitteln bislang ausgeschlossen waren. Eine vorteilhafte Anwendung der Erfindung stellen daher zum Beispiel mit Agrarchemikalien gefüllte Mikrokapseln dar. Durch die Sonneneinwirkung wird die auch photolabile Kapselwand porös bzw. zerstört und kann den Inhalt freisetzen. Da die Zersetzungsgeschwindigkeit der photolabilen Mikrokapseln von der Dosis der empfangenen Sonnenstrahlung und somit von der Strahlungsdauer abhängig ist, setzen einzelne Mikrokapseln ihren Inhalt zu unterschiedlichen Zeiten frei, so daß beispielsweise bei im Boden eingebrachten Mikrokapseln kontinuierlich Agrarchemikalien an den Boden abgegeben werden können. So wird auf einfache Weise eine Langzeitwirkung der Mikrokapseln bzw. des Kapselinhalts erzielt.

Im folgenden wird die Erfindung anhand eines Ausführungsbeispiels und der dazugehörigen drei Figuren näher erläutert.
- Die Figuren 1 und 2: zeigen im schematischen Querschnitt zwei unterschiedliche Verfahrensstufen bei der Herstellung der Mikrokapseln während
- die Figur 3: als Anwendung ein mit den erfindungsgemäßen Mikrokapseln beschichtetes Band darstellt.

### Ausführungsbeispiel:

Es sollen mit einem wasserlöslichen Farbstoff gefüllte Mikrokapseln hergestellt werden. Dazu werden zunächst drei Lösungen vorbereitet:
- Lösung 1:: 0,5 g Bismarck-Brown, 0,8 g Natriumhydroxydplätzchen und 0,7 g Diethylentriamin werden in 20 ml destilliertem Wasser gelöst.
- Lösung 2:: 3,5 g Span 85 (Sorbitantrioleat), das als Dispergierhilfsmittel und Schutzkolloid dient, wird unter Rühren in 70 ml Chloroform/Cyclohexan-Gemisch (1:3) gelöst.
- Lösung 3:: 3,17 g 4,4-Azobis-(4-cyanopentansäurechlorid) werden unter Feuchtigkeitsausschluß in 70 ml Chloroform/Cyclohexan-Gemisch (1:3) gelöst.

Lösung 1 wird filtriert und unter hohen Rührgeschwindigkeiten (mehr als 1000 U/min) in Lösung 2 dispergiert.

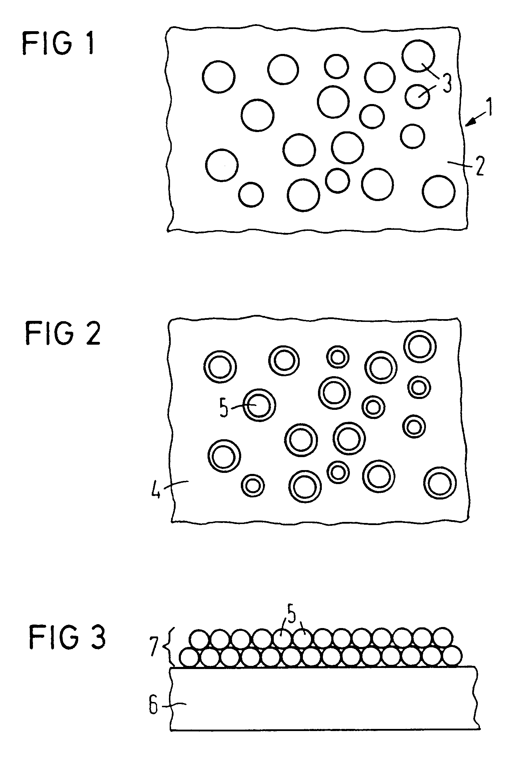

Figur 1 und 2: Die so erhaltene Wasser 3 in Öl 2 enthaltende Suspension 1 wird nur bei reduzierten Rührgeschwindigkeiten (ca. 500 U/min) langsam mit Lösung 3 versetzt, wobei sich durch Grenzflächenpolykondensation Mikrokapseln 5 mit einem Kapselinhalt aus Wasser und Bismarck Brown und einer Kapselwand aus dem folgenden vernetzten Azopolyamid bilden: 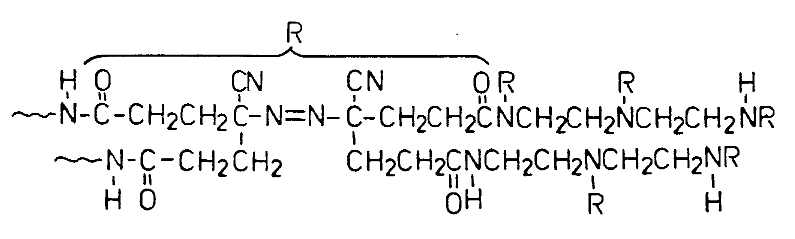
Zur Vervollständigung der Grenzflächenpolykondensation wird die Mikrokapselsuspension 4 ca. 30 Minuten nachgerührt.

Figur 3: Besonders einfach gestaltet sich die Beschichtung einer Folie 6 mit den erfindungsgemäßen Mikrokapseln 5. Die bei den gewählten Ansätzen recht hoch konzentrierte Suspension der Mikrokapseln 5 in der organischen Flotte 4 kann direkt auf der Trägerfolie 6 aufgebracht werden. Das Dispersionsmittel fungiert dabei als Bindemittel und erzeugt einen abriebfesten Film 7.

Für andere Anwendungen kann es erforderlich sein, einen Teil des Lösungsmittels 4 der Mikrokapselsuspension zu entfernen, wobei eine eingedickte Mikrokapselsuspension verarbeitet wird, beispielsweise bei der Herstellung von Reaktionsschreibpapieren.

## Patentansprüche

1. Verfahren zum Erzeugen von eine wäßrige Phase enthaltenden thermo- und/oder photolabilen Mikrokapseln durch Grenzflächenpolykondensation einer durch ein Dispersionsmittel stabilisierten Dispersion mit wäßrigem Kontinuum, wobei die Grenzflächenpolykondensation zwischen zwei, in unterschiedlichen Phasen vorliegenden mehrfunktionellen Reaktionspartnern stattfindet, von denen zumindest einer eine Azo- (- N = N -) oder eine Peroxogruppe (- O - O -) aufweist.

2. Verfahren nach Anspruch 1, **dadurch gekennzeichnet,** daß einer der mehrfunktionellen Reaktionspartner eine labile Gruppe enthält und von der folgenden Formel abgeleitet ist:
R¹ - A - R²
wobei A gleich - O - O - oder - N = N - ist, R¹ und R² unabhängig voneinander für 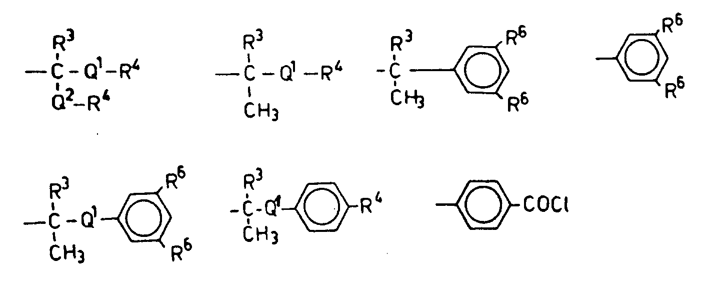 stehen, R³ - CN, Me oder - OAc ist, R⁴für COX, - NH₂, - NR⁵H, - SO₂Cl,- OH oder - NCO steht, R⁵ ein Alkylrest ist, R⁶ für - NH₂, - NHR⁵ oder - OH steht, Q¹ und Q² unabhängig voneinander einen zweiwertigen Alkyl- oder Arylrest darstellen und X Halogen oder H ist.

3. Verfahren nach Anspruch 1 oder 2**, dadurch gekennzeichnet,** daß Reaktionspartner mit mehr als zwei reaktiven Gruppen R⁴ oder R⁶ verwendet werden.

4. Verfahren nach einem der Ansprüche 1 bis 3, **dadurch gekennzeichnet,** daß als Dispersionsmittel Fettsäureester von zyklisiertem Sorbit verwendet werden.

5. Thermo- und/oder photolabile Mikrokapseln, welche eine wäßrige Phase und einen Wirkstoff enthalten und deren Kapselwandpolymer eine Azo- (- N = N -) oder Peroxogruppe (- O - O -) enthält.

6. Mikrokapsel nach Anspruch 5, **dadurch gekennzeichnet,** daß als Wirkstoff ein wasserlöslicher Farbstoff oder ein Farbpigment enthalten ist.

7. Mikrokapsel nach Anspruch 5 oder 6, **dadurch gekennzeichnet,** daß deren Kapselwand durch Grenzflächenpolykondensation erhalten wird und ausgewählt ist aus der Gruppe Polyamid, Polycarbonat, Polyester, Polyharnstoff oder Polyurethan.

8. Mikrokapsel nach einem der Ansprüche 5 bis 7, **dadurch gekennzeichnet,** daß sie als Wirkstoff Agrarchemikalien enthalten und diese unter Sonneneinwirkung kontinuierlich in einem Langzeitprozeß abgeben.

## Claims

1. A method for producing thermolabile and/or photolabile microcapsules containing an aqueous phase by interfacial polycondensation of a dispersion stabilised by a dispersion agent with aqueous continuum, the interfacial polycondensation taking place between two multi-functional reaction partners present in different phases, of which partners at least one has an azo group (- N = N -) or a peroxo group (- O - O -).

2. A method according to Claim 1, characterised in that one of the multi-functional reaction partners contains a labile group and is derived from the following formula:
R¹ - A - R²
with A being equal to - O - O - or - N = N -, R¹ and R², independently of one another, stand for 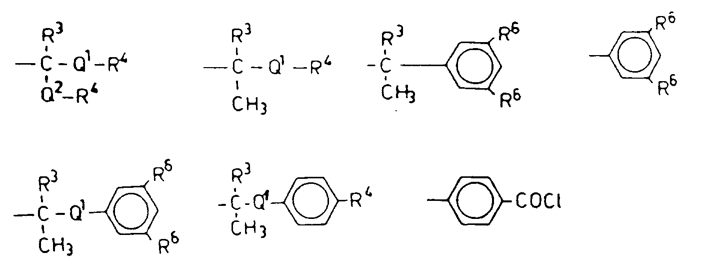 R³ is - CN, Me or - OAc, R⁴ stands for COX, - NH₂, - NR⁵H, - SO₂Cl, - OH or - NCO, R⁵ is an alkyl radical, R⁶ stands for - NH₂, - NHR⁵ or - OH, Q¹ and Q², independently of each other, represent a bivalent alkyl or aryl radical, and X is halogen or H.

3. A method according to Claim 1 or 2, characterised in that reaction partners having more than two reactive groups R⁴ or R⁶ are used.

4. A method according to one of Claims 1 to 3, characterised in that fatty acid esters of cyclised sorbitol are used as dispersion agent.

5. Thermolabile and/or photolabile microcapsules which contain an aqueous phase and an active substance, and the capsule wall polymer of which contains an azo group (- N = N -) or a peroxo group (- O - O -).

6. A microcapsule according to Claim 5, characterised in that a water-soluble dye or a coloured pigment is contained as the active substance.

7. A microcapsule according to Claim 5 or 6, characterised in that the capsule wall thereof is obtained by interfacial polycondensation and is selected from the group polyamide, polycarbonate, polyester, polyurea or polyurethane.

8. Microcapsules according to one of Claims 5 to 7, characterised in that they contain agricultural chemicals as active substance and give them off continuously in a long-term process under the action of the sun.

## Revendications

1. Procédé pour engendrer des microcapsules thermolabiles et/ou photolabiles, contenant une phase aqueuse, par polycondensation à l'interface d'une dispersion, stabilisée par un agent de dispersion, avec un continuum aqueux, la polycondensation à l'interface ayant lieu entre deux partenaires réactionnels multifonctionnels présents en différentes phases, desquels au moins l'un présente un groupe azo (- N = N -) ou un groupe peroxo (- O - O -).

2. Procédé selon la revendication 1,
caractérisé en ce que l'un des partenaires réactionnels multifonctionnels contient un groupe labile et est dérivé de la formule suivante :
R¹ - A - R²
dans laquelle A est - O - O ou - N = N -, R¹ et R² étant, indépendamment l'un de l'autre, 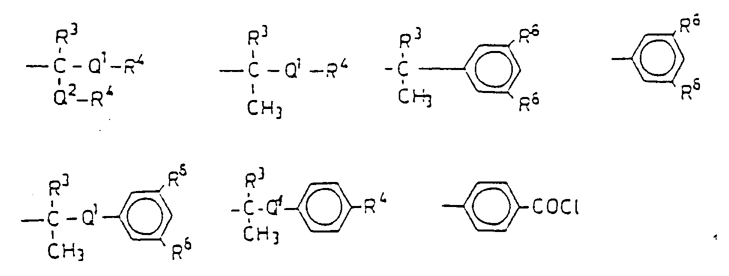 R³ est - CN, Me ou - OAc, R⁴ est COX, - NH₂, - NR⁵H, - SO₂Cl, - OH ou - NCO, R⁵ est un alkyle, R⁶ est - NH₂, - NHR⁵ ou - OH, Q¹ et Q² représentent, indépendamment l'un de l'autre, un alkyle ou aryle bivalent, et X est un halogène ou H.

3. Procédé selon la revendication 1 ou 2,
caractérisé en ce que des partenaires réactionnels présentant plus de deux groupes réactifs R⁴ ou R⁶ sont utilisés.

4. Procédé selon une des revendications 1 à 3,
caractérisé en ce que, comme agent de dispersion, on utilise des esters d'acides gras de sorbitol cyclisé.

5. Microcapsules thermolabiles et/ou photolabiles, lesquelles contiennent une phase aqueuse et une matière active et dont le polymère de la paroi contient un groupe azo (- N = N -) ou peroxo (- O - O -).

6. Microcapsules selon la revendication 5,
caractérisées en ce que, comme matière active, un colorant soluble dans l'eau ou un pigment coloré est contenu.

7. Microcapsules selon la revendication 5 ou 6,
caractérisées en ce que la paroi de celles-ci est obtenue par polycondensation à l'interface et est choisie dans le groupe constitué de polyamide, polycarbonate, polyester, polycarbamide ou polyuréthane.

8. Microcapsules selon une des revendications 5 à 7,
caractérisées en ce qu'elles contiennent, comme matière active, des produits chimiques agraires et dégagent ceux-ci, sous l'action du soleil, de façon continue, dans un processus de longue durée.
